# EUROPÄISCHE PATENTSCHRIFT

(11) **EP 0 703 619 B1**
(45) Veröffentlichungstag und Bekanntmachung des Hinweises auf die Patenterteilung: **03.11.1999**
(21) Anmeldenummer: 95113435.2
(22) Anmeldetag: 26.08.1995
(51) Int. Cl.: H01L 25/065, H01L 21/98

(54) **Verfahren zur Herstellung einer dreidimensionalen integrierten Schaltung unter Erreichung hoher Systemausbeuten**
Method for fabricating a three dimensional integrated circuit for a higher system gain achievement
Procédé pour fabriquer un circuit intégré tridimensionnel pour atteindre des systèmes à rendement plus haut

(30) Priorität: 22.09.1994 DE 4433833
(43) Veröffentlichungstag der Anmeldung: 27.03.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: Ramm, Peter, Dr., D-85276 Pfaffenhofen (DE); Buchner, Reinhold, Dipl.-Phys., D-85774 Unterföhring (DE)

(56) Entgegenhaltungen:
- EP-A- 0 531 723
- DE-C- 4 314 913
- INT. ELECTRON DEVICES MEETING, 8. Dezember 1991, WASHINGTON Seiten 657 - 660 Y. HAYASHI ET AL. 'a new three dimensional ic fabrication technology, stacking thin film dual-cmos layers'
- MICROELECTRONIC ENGINEERING, Bd.15, Nr.1/4, Oktober 1991, AMSTERDAM Seiten 167 - 174 T. MORIYA ET AL. 'RESULTS of the three-dimensional integrated circuits project in japan'

## Beschreibung

Die Erfindung betrifft ein Verfahren zur Herstellung einer dreidimensionalen integrierten Schaltung unter Erreichung hoher Systemausbeuten. Unter dreidimensionaler Integration versteht man die vertikale Verbindung von Bauelementen, die mittels Planartechnik hergestellt wurden. Die Vorteile eines dreidimensional integrierten mikroelektronischen Systems sind u.a. die bei gleichen Designregeln erreichbaren höheren Packungsdichten und Schaltgeschwindigkeiten gegenüber zweidimensionalen Systemen. Letzteres ist zum einen bedingt durch kürzere Leitungswege zwischen den einzelnen Bauelementen oder Schaltungen, zum anderen durch die Möglichkeit der parallelen Informationsverarbeitung. Die Steigerung der Leistungsfähigkeit des Systems ist bei Realisierung einer Verbindungstechnik mit örtlich frei wählbaren höchstintegrierbaren vertikalen Kontakten optimal.

Zur Herstellung dreidimensionaler Schaltungsanordnungen mit frei wählbaren vertikalen Kontakten sind folgende Verfahren bekannt:
Y. Akasaka, Proc. IEEE 74 (1986) 1703, schlägt vor, auf eine fertig prozessierte Bauelementeschicht polykristallines Silizium abzuscheiden und zu rekristallisieren, so daß in der rekristallisierten Schicht weitere Bauelemente gefertigt werden können. Nachteile dieser Methode sind die ausbeutereduzierende Degradation der Bauelemente in der unteren Ebene durch die hohe thermische Belastung beim Rekristallisierungsprozeß, sowie die notwendigerweise serielle Prozessierung des Gesamtsystems. Letzteres bedingt zum einen entsprechend lange Durchlaufzeiten bei der Fertigung und hat zum anderen eine Ausbeuteminderung durch Aufsummierung der prozeßbedingten Ausfälle zur Folge. Beides erhöht die Fertigungskosten beträchtlich gegenüber einer Prozessierung der einzelnen Ebenen getrennt voneinander in verschiedenen Substraten.

Aus Y. Hayashi et al., Proc. 8th Int. Workshop on Future Electron Devices, 1990, p. 85, ist es bekannt, zunächst die einzelnen Bauelementeebenen getrennt voneinander in verschiedenen Substraten herzustellen. Anschließend werden die Substrate auf wenige Mikrometer gedünnt, mit Vorder- und Rückseitenkontakten versehen und mittels eines Bondverfahrens vertikal verbunden. Für die Bereitstellung der Vorder- und Rückseitenkontakte sind jedoch Sonderprozesse notwendig sind, die in der Standard - Halbleiterfertigung (CMOS) nicht vorgesehen sind, nämlich MOS - inkompatible Materialien (z.B. Gold) und Rückseitenstrukturierung des Substrates.

Die US 4,939,568 beschreibt ein Verfahren zur Herstellung einer dreidimensionalen integrierten Schaltungsstruktur durch Stapelung einzelner ICs zu einem Einzelchipstapel auf einem Trägersubstrat. Hierzu wird zunächst ein Substrat mit fertigprozessierten ICs in einzelne Chips unterteilt, womit die Prozessierung auf Waferebene beendet ist. Die Chips werden getestet, und ein erster einzelner Chip wird mittels Thermokompression auf ein Trägersubstrat aufgebracht. Nach diesem Schritt wird ein weiterer Chip in der gleichen Weise auf den ersten Chip aufgebracht. Es wird somit zunächst ein erster Chipstapel fertiggestellt, bevor mit der Herstellung eines weiteren Chipstapels auf einem anderen Trägersubstrat begonnen wird. Eine Weiterprozessierung der Chipstapel auf Waferebene ist mit diesem Verfahren daher nicht möglich.

Aus der EP-A-0531723 ist ein Verfahren zur Herstellung dreidimensionaler Multichip-Stapel bekannt. Dabei werden vereinzelte Chips dergestalt mit einem geeigneten Träger verbunden, daß die Schutzoberfläche des Chips angrenzend an die obere Oberfläche des Trägers angeordnet ist. In einem folgenden Schritt wird die freiliegende zweite Oberfläche des Chips in einer geeigneten Ätzlösung geätzt. Anschließend werden weitere Schichten aufgebracht, und der Stapelprozeß wird dann wiederholt, indem Chips jeweils aufeinander hinzugefügt werden, wobei jeder seine aktive Schicht angrenzend an die zuletzt gedünnte freiliegende Oberfläche des Stapels positioniert hat. Dabei werden bei einer Vereinzelung der Chips jeweils nur die funktionsfähigen Chips ausgewählt. Alternativ kann auch eine wafermäßige Bearbeitung der Chips stattfinden, dabei findet jedoch keine Auswahl der funktionsfähigen Chips statt.

Darüber hinaus wird in International Electron Devices Meeting, 8. Dezember 1991, Seiten 25.6.1. bis 25.6.4.,Y. Hayashi et al. "A New Three-Dimensional IC Fabrication Technology, Stacking Thin Film Dual-CMOS Layers" eine neuartige dreidimensionale integrierte Schaltung beschrieben, bei dem Blöcke aus sogenanntem Dünnfilm DUAL-CMOS ICs miteinander verbunden werden. In diesen DUAL-CMOS ICs werden p-MOSFETs auf n-MOSFETs gestapelt, indem eine Laserstrahl-Tempertechnik verwendet wird. Durch mechanisch-chemisches Polieren werden die Substrate der integrierten Schaltungen gedünnt und dann miteinander verbunden. Darüber hinaus ist aus der deutschen Patentschrift Nr. 43 14 913 ein Verfahren zur Herstellung eines Bauelements mit einer Kontaktstrukturierung für vertikale Kontaktierung mit weiteren Halbleiterbauelementen bekannt. Das Halbleiterbauelement mit einer Kontaktstrukturierung für vertikale Kontaktierung mit weiteren Bauelementen weist ein Substrat auf, das auf einer Oberseite eine Schichtstruktur mit zu kontaktierenden Bereichen aufweist, bei dem mindestens ein Metallstift vorhanden ist, der dieses Substrat senkrecht zu der Schichtstruktur durchbohrt, bei dem das Substrat soweit gedünnt ist, daß der Metallstift die Unterseite des Substrats überragt und bei der gegebenenfalls auf der Oberseite Metallkontakte aus niedrigschmelzendem Metall vorhanden sind.

Ein wesentlicher Nachteil der bisher genannten Verfahren ist dadurch bedingt, daß die in der Siliziumtechnologie zur Verfügung stehenden Geräte nur eine Bearbeitung (Prozessierung) von scheibenförmigen Substraten, den sog. Wafern, zulassen. Eine Prozessierung davon verschiedener Substrate, insbesondere von einzelnen Chips, ist nur in experimentellen Versuchsanlagen möglich, jedoch nicht im Rahmen einer industriellen Fertigung mit den geforderten hohen Ausbeuten.

Die US 4,954,875 beschreibt ein Verfahren zur dreidimensionalen Integration durch Stapelung einzelner Wafer, bei dem die Verbindung der einzelnen Bauelementeebenen über besonders geformte Vias hergestellt wird.
In der EP-A 0 531 723 ist ein Verfahren zur Herstellung dreidimensionaler Chipstapel offenbart, bei dem ein Wafersubstrat mit fertigprozessierten Bauelementeebenen auf einer Seite mit einem Trägersubstrat verbunden und auf der gegenüberliegenden Seite gedünnt wird. Weitere Wafer werden in der gleichen Weise bearbeitet und aufeinander gestapelt.
Beim Zusammenfügen von Substraten, die eine Vielzahl von identischen Bausteinen, den sogenannten Chips, enthalten, ergibt sich die resultierende Ausbeute eines mehrlagigen Systems aus dem Produkt der Einzelausbeuten. Dies führt dazu, daß die Ausbeute eines mehrere Bauelementeebenen umfassenden Systems, wie das der US 4,954,875 oder der EP-A 0 531 723 nach den bekannten Verfahren drastisch abnimmt. So erhält man bei einer Ausbeute einer Einzelebene von 80% bei einem Gesamtsystem aus 10 Ebenen nur mehr eine resultierende Gesamtausbeute von etwa 10%, womit ein derartiges System unwirtschaftlich wird und der Einsatz dieser Technik auf wenige spezielle Einsatzfelder beschränkt wird. Die Ausbeute eines Bauelementesubstrates hängt dabei auch von der Art der Schaltungen und des verwendeten Herstellungsprozesses ab. So erzielt man z.B. in der Fertigung von Speicherbausteinen sehr hohe Ausbeuten, während bei Logikbausteinen, wie Mikroprozessoren, eine deutlich geringere Ausbeute erreicht wird. Insbesondere wenn mehrere Arten solcher Schaltungen übereinandergestapelt werden, wird damit die Gesamtausbeute überproportional durch die Schaltungsart mit der geringsten Ausbeute bestimmt.

Der Erfindung liegt die Aufgabe zugrunde, ein Verfahren zur Herstellung einer dreidimensionalen integrierten Schaltung anzugeben, mit dem unter Verwendung der üblichen industriellen Standardausrüstung auf Waferebene eine deutliche Ausbeutesteigerung gegenüber bisher bekannten Verfahren erzielt wird.

Diese Aufgabe wird erfindungsgemäß mit dem Verfahren nach Anspruch 1 gelöst. Besondere Ausgestaltungen des Verfahrens sind Gegenstand der Unteransprüche.

In dem erfindungsgemäßen Verfahren wird zum Aufbau eines mehrere Bauelementeebenen umfassenden Systems ein zusätzliches Trägersubstrat verwendet, das keine Bauelementestrukturen enthält. Ein fertig prozessiertes Substrat, das Schaltungsstrukturen und Metallisierungsebenen umfaßt, wird einem Funktionstest unterzogen, mit dem die intakten Chips des Substrates selektiert werden. Anschließend wird dieses Substrat mit einem Hilfssubstrat verbunden, von der Rückseite her gedünnt und in einzelne Chips zerlegt. Statt des Dünnens des Substrates bis nahe an die Bauelementestrukturen heran kann auch im Falle eines SOI-Substrates der Substratbereich unterhalb der Oxidschicht entfernt werden. Dann werden selektierte, intakte Chips mit dem Trägersubstrat, beispielsweise über eine Haftschicht, verbunden, wobei die Anordnung der Einzelchips nebeneinander in einem vorgegebenen Schema erfolgt. Die Chips werden somit auf dem Trägersubstrat zu einer neuen Chipebene zusammengesetzt. Auf diese Weise wird ein Wafer bereitgestellt, der in der Bauelementeebene nur intakte Bauelemente und Schaltkreise enthält.
Schließlich wird das (zerteilte) Hilfssubstrat entfernt.

Da auf dem Trägersubstrat nun einzelne Chips aufgebracht worden sind, ist keine zusammenhängende Oberfläche mehr vorhanden (Gräben zwischen den Chips), so daß bestimmte Prozeßschritte, insbesondere Photolithographiemodule, nicht mehr mit hoher Ausbeute durchgeführt werden können. Deshalb wird nun vorzugsweise ein Planarisierungsschritt eingefügt (Anspruch 9). Danach kann das Substrat, das in der Bauelementeebene nur noch getestete und funktionsfähige Chips enthält, in gängigen Fertigungsanlagen weiter verarbeitet werden.

Die Planarisierung kann mit verschiedenen Verfahren durchgeführt werden. Dabei wird zuerst eine Isolationsschicht, wie z.B. Spin-on-Glas oder ein CVD - Oxid, aufgebracht, um die Gräben aufzufüllen. Anschließend wird die Oberfläche eingeebnet, was durch Rückätzen, mechanisches oder chemomechanisches Schleifen erfolgt.

Weitere Prozesse, die nicht auf Chipebene realisierbar sind, können nun nach dem Planarisierungsschritt problemlos an dem Trägersubstrat mit vorselektierten Chips durchgeführt werden.

Nach Fertigstellung der ersten Bauelementeebene wird eine weitere Bauelementeebene z.B. in der gleichen Weise chipweise aufgebracht und die Oberfläche planarisiert (Anspruch 2).
Anschließend wird z.B. über Vialöcher (Anspruch 10), die bereits bei der Prozessierung der Einzelsubstrate in die Chips eingebracht wurden und nun bis zu einer Metallisierungsebene der darunterliegenden Bauelementeebene durchgeätzt werden, die elektrische Verbindung zwischen je einer Metallisierung der oberen und der unteren Bauelementeebene hergestellt. Dabei wird die Photomaske zur Strukturierung auf jeden einzelnen Chip über Justierstrukturen separat justiert, um etwaige Maßabweichungen durch das Aufbringen der einzelnen Chips auszugleichen und eine hohe Justiergenauigkeit zu erreichen.

Soll zusätzlich eine weitere Bauelementeebene aufgebracht werden (Anspruch 3), so wird der vorhandene Teilstapel (d.h. das ursprüngliche Trägersubstrat mit sämtlichen bisher aufgebrachten Bauelementeebenen) auf seine Funktionsweise getestet, mit einem Hilfssubstrat versehen, das ursprüngliche Trägersubstrat entfernt, und das Hilfssubstrat mit den Bauelementeebenen in Chips vereinzelt. Die funktionsfähigen Chips werden über eine Haftschicht mit einem neuen Trägersubstrat verbunden, die Hilfssubstrate entfernt und eine Planarisierung der Oberfläche durchgeführt. Dann wird in gleicher Weise eine weitere Bauelementeebene chipweise aufgebracht, die Oberfläche planarisiert und die elektrische Verbindung hergestellt.

Die Anzahl der Ebenen, die aufgebracht werden, ist bei diesem Verfahren nicht beschränkt. Außerdem kann nicht nur eine Einzelebene, sondern auch ein bereits aus mehreren Ebenen bestehender Teilstapel chipweise aufgebracht werden.

Als Substrate sind monokristalline Siliziumsubstrate, SOI - Substrate oder Substrate verschiedener Technologiefamilien, wie z.B. III - V - Halbleiter geeignet. Als Trägersubstrat sind neben mono- oder polykristallinen Siliziumsubstraten, die mit einer Isolationsschicht, wie z.B. Siliziumoxid, versehen sein können, auch andere Materialien verwendbar, die zu Halbleiterprozessen kompatibel sind, wie z.B. Quarz- oder Glassubstrate. Von Vorteil ist es dabei, wenn die thermischen Ausdehnungskoeffizienten von Trägersubstrat und Bauelementesubstrat angepaßt sind, um mechanische Spannungen aufgrund von durch Prozeßschritte bedingte Temperaturzyklen gering zu halten. Da die verwendeten Bauelementesubstrate bereits Metallisierungsebenen umfassen, die üblicherweise Aluminium oder eine Aluminiumlegierung enthalten, sind die nachfolgenden Prozeßschritte in der Regel auf maximale Temperaturen von etwa 400°C beschränkt. Zusätzlich kann die Haftschicht als Pufferschicht zum Abbau von mechanischem Streß oder als Passivierungsschicht (Anspruch 7) fungieren. Weiterhin kann die Haftschicht eine Planarisierung der Oberfläche bewirken (Anspruch 8). Als Haftschicht kann dabei ein organisches Material, wie z.B. Polyimid oder Photolack verwendet werden.

Insgesamt werden bei diesem Verfahren zur Herstellung einer dreidimensionalen integrierten Schaltung nur bekannte und eingeführte Verfahrensschritte verwendet, so daß keine neuen Prozesse entwickelt werden müssen.
Das erfindungsgemäße Verfahren eignet sich hervorragend zum Aufbau von mehrlagigen Systemen. Da beim dem Verfahren nur vorgetestete Elemente verwendet und nur funktionsfähige Teilstapel weiter verarbeitet werden, wird vermieden, daß funktionsfähige Chips auf bereits defekte Bauelementestapel aufgebracht und damit wertlos werden. Dadurch erhöht sich in vorteilhafter Weise die Gesamtausbeute des Systems, so daß eine deutliche Kostenreduktion zu erzielen ist.

Im folgenden wird die Erfindung anhand der Zeichnungen und eines Ausführungsbeispiels näher erläutert.

Dabei zeigen:
- Fig. 1: ein erstes Bauelementesubstrat mit Schaltungsstrukturen und Metallisierungsebenen,
- Fig. 2: das erste Bauelementesubstrat mit Haftschicht und Hilfssubstrat,
- Fig. 3: ein Trägersubstrat mit Haftschicht,
- Fig. 4: ein Trägersubstrat mit einer chipweise aufgebrachten ersten Bauelementeebene nach Planarisierung der Oberfläche,
- Fig. 5: ein zweites Bauelementesubstrat mit Schaltungsstrukturen und Metallisierungsebenen,
- Fig. 6: ein Trägersubstrat mit zwei chipweise aufgebrachten Bauelementeebenen nach Planarisierung der Oberfläche,
- Fig. 7: ein Trägersubstrat mit zwei vertikal verbundenen Bauelementeebenen,
- Fig. 8: ein Hilfssubstrat mit zwei vertikal verbundenen Bauelementeebenen nach Entfernen des Trägersubstrates,
- Fig. 9: ein Trägersubstrat mit zwei chipweise aufgebrachten Bauelementestapeln aus zwei Bauelementeebenen mit den Hilfssubstraten, und
- Fig. 10: ein Trägersubstrat mit zwei chipweise aufgebrachten Bauelementestapeln aus zwei Bauelementeebenen nach Planarisierung der Oberfläche.

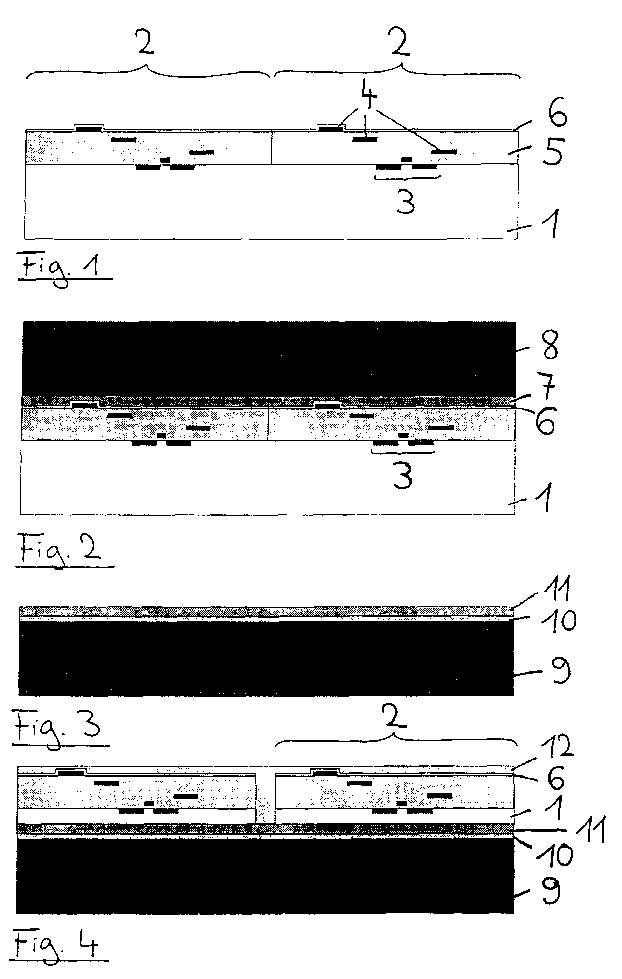

Ein erstes Bauelementesubstrat 1 aus z.B. monokristallinem Silizium umfaßt mehrere, nach einem definierten Schema angeordnete, üblicherweise identische Chips 2, die Schaltungsstrukturen 3, wie beispielsweise einen MOS - Transistor, und eine oder mehrere Metallisierungsebenen 4 enthalten, die typischerweise aus Aluminum, einer Aluminiumlegierung oder anderen Materalien, wie Kupfer oder Wolfram, bestehen und zur elektrischen Isolation von einer Oxidschicht 5, die zu Planarisierungszwecken auch mit Bor und/oder Phosphor dotiert sein kann, umgeben sind. Die oberste Metallisierungsebene 4 kann dabei auch von einer Passivierungsschicht 6 aus beispielsweise Siliziumoxid und Siliziumnitrid bedeckt sein. Weiterhin sind Justagestrukturen zum genauen Zusammenfügen mehrerer Ebenen implementiert (in Fig. 1 nicht gezeigt). Unterhalb der Schaltungsstrukturen 3 weist das Substrat eine Dicke von z.B. 625 µm auf. Dieses Bauelementesubstrat stellt das untere Substrat des mehrlagigen Systems dar (Fig. 1).

Nach Fertigstellung des Bauelementesubstrates 1 wird die Passivierung 6 auf der obersten Metallisierungsebene an bestimmten Meßstellen geöffnet. Danach werden die einzelnen Chips des Substrates einem Funktionstest unterzogen und die defekten Chips gekennzeichnet (z.B. mit einem Tintenstrahl). Anschließend wird erneut eine Passivierungsschicht aufgebracht, um die offenliegenden Meßstellen wieder zu schützen.

Auf die Oberfläche des Substrates 1 wird ganzflächig eine Haftschicht 7 aus einem organischen Material, wie Polyimid oder Photolack, aufgebracht. Diese Haftschicht 7 mit einer Dicke von typischerweise 1 - 2 µm kann außerdem eine Planarisierung der Oberfläche bewirken. Auf die Haftschicht 7 wird schließlich ein Hilfssubstrat 8, wie beispielsweise ein Silizium- oder Quarzwafer, geklebt. Das Hilfssubstrat 8 wird als Handlingsubstrat für die weiteren Prozeßschritte verwendet und schützt die Oberfläche des Bauelementesubstrates 1 bei der weiteren Bearbeitung. (Fig. 2).

Danach wird das Bauelementesubstrat 1 durch Ätzen und/oder Schleifen von der Rückseite her gedünnt, so daß die Dicke des Substrates 1 unterhalb der Schaltungsstrukturen 3 nur noch wenige Mikrometer, typischerweise 1 - 5 µm, beträgt. Dabei hängt die gewählte Restdicke auch von der Art der enthaltenen Schaltungen ab.

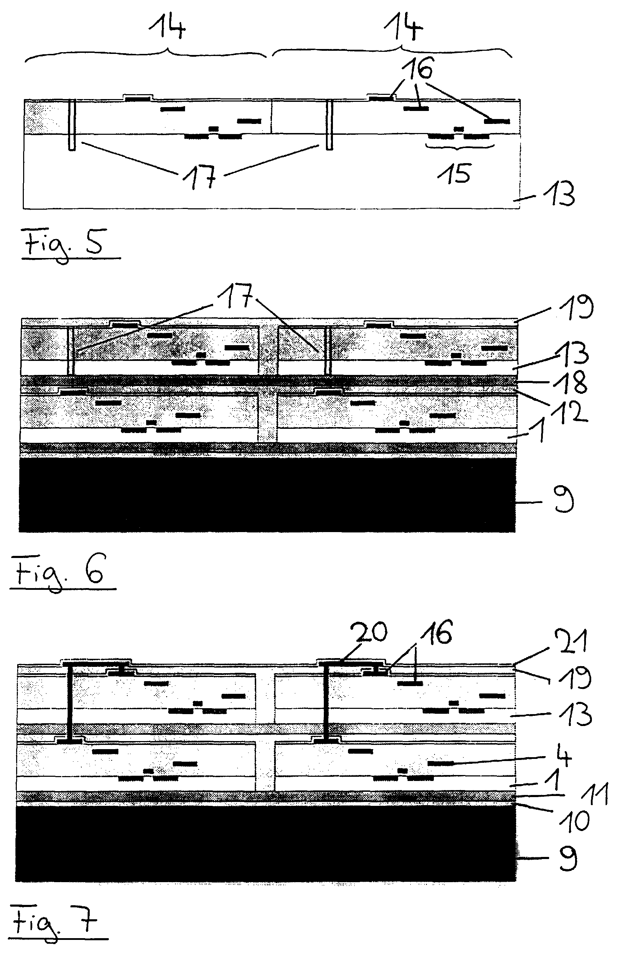

Ein Trägersubstrat 9, das z.B. aus mono- oder polykristallinem Silizium besteht und eventuell mit einer Isolationsschicht 10, wie Siliziumoxid, bedeckt ist, enthält keine Schaltungsstrukturen. Auf dieses Trägersubstrat 9 wird nun eine Haftschicht 11 aus z.B. Polyimid oder Photolack, aufgebracht (Fig. 3).

Nun wird das Bauelementesubstrat 1 mit dem Handlingsubstrat 8 in einzelne Chips zerteilt. Dies kann dabei mit einem Ätzprozeß, durch Sägen oder mit einem Laser erfolgen. Daraufhin werden die gekennzeichneten, intakten Chips 2 auf das Trägersubstrat 9 in einer vorgegebenen Anordnungweise nebeneinander aufgebracht. Anschließend wird das Handlingsubstrat 8 durch Abätzen oder Abschleifen entfernt und die freiliegende Haftschicht 7 typischerweise mit einem Sauerstoffplasma oder einem Lösungsmittel ganzflächig entfernt. Nach dem Aufkleben der Chips 2 weist die Oberfläche des Trägersubstrates 9 mit den Bauelementsubstraten 1 nun Gräben zwischen den einzelnen Chips 2 auf, die ein sehr niedriges Aspektverhältnis besitzen. Durch einen Planarisierungsschritt, bei dem die Schicht 12 (z.B. CVD-Oxid) abgeschieden wird, werden diese Gräben nun aufgefüllt und eine ebene Oberfläche erzeugt. Dabei kann die Passivierungsschicht 6 als Stoppschicht für das Rückätzen bzw. Rückschleifen dienen. Das Trägersubstrat 9 mit der aufgebrachten ersten Bauelementeebene läßt sich nun wie ein übliches Siliziumsubstrat mit Standard - Technologiegeräten weiterverarbeiten (Fig. 4).

Ein zweites Bauelementesubstrat 13 umfaßt ebenfalls mehrere, nach einem definierten Schema angeordnete, üblicherweise identische Chips 14, die Schaltungsstrukturen 15, wie beispielsweise einen MOS - Transistor, und eine oder mehrere Metallisierungsebenen 16 enthalten. Dieses Substrat 13 ist im wesentlichen ähnlich aufgebaut wie das erste Bauelementesubstrat 1, die Schaltungsstrukturen 15 sind aber in der Regel von ihrer Funktion her unterschiedlich. Desweiteren weist das zweite Bauelementesubstrat Vialöcher 17 an den Stellen auf, an denen später die elektrische Kontaktierung zu darunterliegenden Schaltungsstrukturen erfolgen soll. Die Vialöcher 17 sind so tief, daß sie bis unterhalb der Schicht mit Schaltungsstrukturen 15 reichen (Fig. 5).
Auch dieses Bauelementesubstrat 13 wird einem Funktionstest unterzogen, die defekten Chips werden gekennzeichnet, und eine Haftschicht und ein Hilfssubstrat werden in ähnlicher Vorgehensweise aufgebracht. Schließlich wird das Bauelementesubstrat 13 ebenfalls durch Ätzen und / oder Schleifen von der Rückseite her bis an die Vialöcher 17 heran gedünnt. Das zweite Bauelementesubstrat 13 mit dem Handlingsubstrat wird nun in einzelne Chips zerteilt und die gekennzeichneten, intakten Chips 14 werden justiert auf das, mit einer Haftschicht 18 versehene, Trägersubstrat 9 mit der ersten Bauelementeebene 1 aufgebracht. Die Haftschicht 18 mit einer Dicke von typischerweise 1 - 2 µm kann dabei eine Planarisierung der Oberfläche bewirken. Anschließend wird das Handlingsubstrat durch Abätzen oder Abschleifen abgetragen und die freiliegende Haftschicht ganzflächig entfernt. Daraufhin wird nach Abscheidung der Schicht 19 (z.B. CVD-Oxid), ebenfalls ein Planarisierungsschritt durchgeführt, mit dem eine ebene Oberfläche erzeugt wird (Fig. 6).

Danach wird schließlich die vertikale Verbindung 20 zwischen einer Metallisierungsebene 16 der oberen Bauelementeebene (Substrat 13) und einer Metallisierungsebene 4 der unteren Bauelementeebene (Substrat 1) hergestellt. Dazu werden mit einem Photolithographieschritt ein Kontaktloch zu einer Metallisierungsebene 16 der oberen Bauelementeebene und die vorbereiteten Vialöcher 17 bis zu einer Metallisierungsebene 4 der unteren Bauelementeebene geöffnet und durch Metallabscheidung und Strukturierung eine elektrische Verbindung 20 realisiert. Schließlich wird auf die Oberfläche noch eine Passivierungsschicht 21 abgeschieden (Fig. 7).

Die elektrische Kontaktierung kann selbstverständlich auch auf andere Weise realisiert werden, so z.B. bereits beim Aufbringen der Chips auf das untere Substrat mittels vorbereiteter Vorder- und Rückseitenkontakte (vgl. Beschreibungseinleitung: Y. Hayashi et al.).

Soll nun eine weitere Bauelementeebene aufgebracht werden, so wird das bereits realisierte System aus zwei Lagen einem Funktionstest unterzogen und die defekten Chips werden gekennzeichnet. Nachfolgend wird eine Passivierungsschicht ganzflächig abgeschieden, um die Oberfläche zu schützen. Daraufhin wird in der bereits dargestellten Weise eine Haftschicht 22 und ein Hilfssubstrat 23 aufgebracht. Das Trägersubstrat 9 einschließlich der Isolationsschicht 10 und die Haftschicht 11 unter der ersten Bauelementeebene (Substrat 1) werden schließlich z.B. durch Ätzen und / oder Schleifen von der Rückseite her entfernt (Fig. 8).
Das Trägersubstrat kann z.B. auch durch Wegätzen der Haftschicht 11 entfernt werden und dann erneut als Trägersubstrat für nachfolgende Prozeßschritte eingesetzt werden (Anspruch 4).

Nun wird das Hilfssubstrat 23 zusammen mit den beiden Bauelementeebenen in einzelne Chips (Teilstapel) 24 zerteilt, woraufhin die gekennzeichneten, intakten Chips justiert auf ein neues Trägersubstrat 26, das eventuell mit einer Isolationsschicht 27 und mit einer Haftschicht 28 versehen ist, aufgebracht werden (Fig. 9).

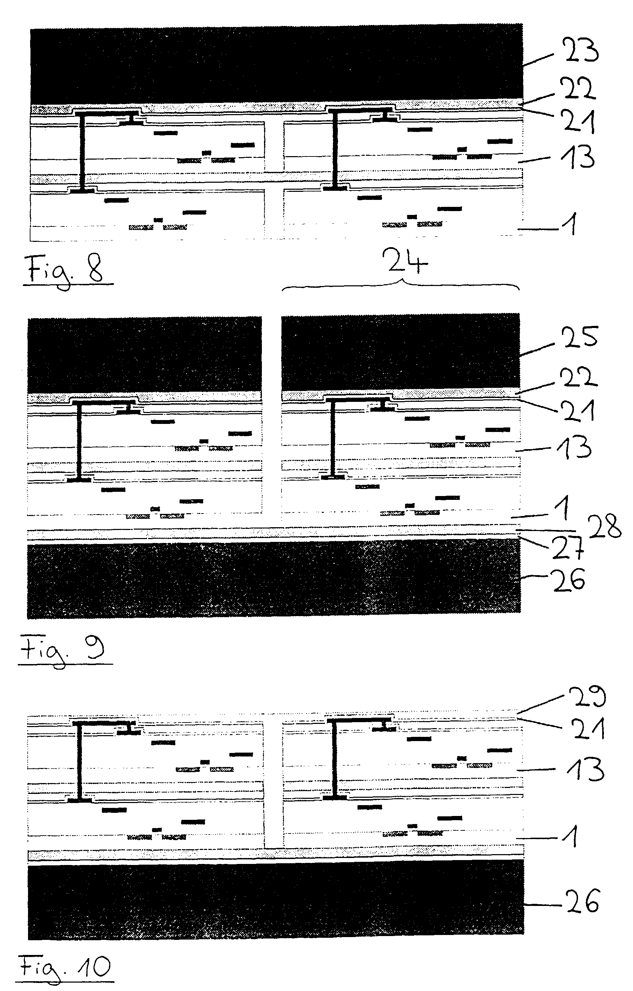

Anschließend werden die Handlingsubstrate 25 (zerteiltes Handlingsubstrat 23) durch Abätzen und / oder Abschleifen abgetragen und die freiliegende Haftschicht 22 ganzflächig entfernt. Danach wird nach Abscheiden der Schicht 29 (z.B. CVD-Oxid) ebenfalls ein Planarisierungsschritt durchgeführt, mit dem eine ebene Oberfläche erzeugt wird. Damit erhält man ein Substrat, welches nur voll funktionsfähige Chips mit zwei Bauelementeebenen enthält (Fig. 10).

In ähnlicher Weise können weitere Bauelementeebenen hinzugefügt werden, wobei jeweils nur funktionsfähige Teilsysteme weiter verarbeitet werden.

## Patentansprüche

1. Verfahren zur Herstellung einer dreidimensionalen integrierten Schaltung unter Erreichung hoher Systemausbeuten mit folgenden Verfahrensschritten:
- Bereitstellen eines ersten Substrates (1), das auf einer ersten Seite eine oder mehrere fertigprozessierte Bauelementeebenen (3) enthält, die nebeneinander eine Vielzahl von unabhängigen Bauelementen oder Schaltkreisen aufweisen, wobei Bauelemente oder Schaltkreise mehrerer Bauelementeebenen Bauelementestapel bilden;
- Funktionstest der einzelnen Bauelemente, Bauelementestapel oder Schaltkreise des ersten Substrates zur Unterscheidung funktionsfähiger von nicht funktionsfähigen Bauelementen, Bauelementestapeln oder Schaltkreisen,
- Verbinden des ersten Substrates (1) mit einem Hilfssubstrat (8) auf der ersten Seite;
- Dünnen oder Entfernen des ersten Substrates (1) auf der Seite, die der ersten Seite gegenüberliegt, bis nahe an die eine oder mehrere fertigprozessierte Bauelementeebenen;
- Zerteilen des Hilfssubstrates (8) mit den verbundenen Bauelementeebenen zu einzelnen Chips, die jeweils funktionsfähige oder nicht funktionsfähige Bauelemente, Bauelementestapel oder Schaltkreise enthalten;
- Bereitsellen eines Trägersubstrates (9);
- Justiertes Aufbringen von Chips (2), die funktionsfähige Bauelemente, Bauelementestapel oder Schaltkreise enthalten, nebeneinander auf das Trägersubstrat (9), sodaß eine Chipebene entsteht;
- Entfernen des Hilfssubstrates (8);
- Aufbringen zumindest einer weiteren Bauelementeebene auf die Bauelementeebenen des Trägersubstrates.

2. Verfahren nach Anspruch 1,
**dadurch gekennzeichnet,**
daß das Aufbringen der weiteren Bauelementeebene folgende Verfahrensschritte umfaßt:
- Bereitstellen eines zweiten Substrates (13), das auf einer zweiten Seite eine oder mehrere fertigprozessierte Bauelementeebenen (15) enthält, die nebeneinander eine Vielzahl von unabhängigen Bauelementen oder Schaltkreisen aufweisen, wobei Bauelemente oder Schaltkreise mehrerer Bauelementeebenen Bauelementstapel bilden;
- Funktionstest der einzelnen Bauelemente, Bauelementstapel oder Schaltkreise zur Unterscheidung funktionsfähiger von nicht funktionsfähigen Bauelementen, Bauelementstapeln oder Schaltkreisen;
- Verbinden des zweiten Substrates (13) mit einem Hilfssubstrat auf der zweiten Seite;
- Dünnen oder Entfernen des zweiten Substrates (13) auf der Seite, die der zweiten Seite gegenüberliegt;
- Zerteilen des Hilfssubstrates mit den verbundenen Bauelementeebenen zu einzelnen Chips, die jeweils funktionsfähige oder nicht funktionsfähige Bauelemente, Bauelementstapel oder Schaltkreise enthalten;
- Justiertes Aufbringen von Chips, die funktionsfähige Bauelemente, Bauelementstapel oder Schaltkreise enthalten, nebeneinander auf die Bauelementeebenen des Trägersubstrates (9);
- Entfernen des Hilfssubstrates;
- Herstellen der elektrischen Kontakte zwischen den Bauelementen, Bauelementstapeln oder Schaltkreisen der aufgebrachten Chips und den Bauelementen, Bauelementstapeln oder Schaltkreisen auf dem Trägersubstrat, wobei dieser Verfahrensschritt bereits beim Aufbringen der Chips erfolgen kann.

3. Verfahren nach Anspruch 1 oder 2,
**dadurch gekennzeichnet,**
daß zum Aufbau einer dreidimensionalen integrierten Schaltung mit mehr als zwei Bauelementeebenen das Verfahren mehrmals nacheinander durchgeführt wird, wobei als erstes Substrat bei jeder wiederholten Durchführung des Verfahrens das Trägersubstrat mit den aufgebrachten Bauelementeebenen verwendet wird, das durch die jeweils vorhergehenden Verfahrensschritte bereitgestellt wird.

4. Verfahren nach Anspruch 3,
**dadurch gekennzeichnet,**
daß das gleiche Trägersubstrat mehrfach verwendet wird.

5. Verfahren nach einem der Ansprüche 1 bis 4,
**dadurch gekennzeichnet,**
daß das Hilfssubstrat über eine Haftschicht mit dem ersten und/oder dem zweiten Substrat verbunden wird.

6. Verfahren nach einem der Ansprüche 1 bis 5,
**dadurch gekennzeichnet,**
daß die Chips mittels einer Haftschicht auf das Trägersubstrat oder auf Bauelementeebenen des Trägersubstrates aufgebracht werden.

7. Verfahren nach Anspruch 5 oder 6,
**dadurch gekennzeichnet,**
daß eine Haftschicht mit passivierenden Eigenschaften verwendet wird.

8. Verfahren nach einem der Ansprüche 5 bis 7
**dadurch gekennzeichnet,**
daß eine Haftschicht verwendet wird, die eine Planarisierung der Oberfläche bewirkt.

9. Verfahren nach einem der Ansprüche 1 bis 8,
**dadurch gekennzeichnet,**
daß Gräben, die nach dem justierten Aufbringen der einzelnen Chips zwischen diesen entstehen, planarisiert werden.

10. Verfahren nach einem der Ansprüche 2 bis 9,
**dadurch gekennzeichnet,**
daß das Herstellen der elektrischen Kontakte zwischen den Bauelementen, Bauelementstapeln oder Schaltkreisen der aufgebrachten Chips und den Bauelementen, Bauelementstapeln oder Schaltkreisen des Trägersubstrates über Kontakt- und/oder Vialöcher (17) erfolgt.

11. Verfahren nach einem der Ansprüche 1 bis 10,
**dadurch gekennzeichnet,**
daß das Dünnen des ersten und/oder zweiten Substrates mittels Ätzen und/oder Schleifen erfolgt.

12. Verfahren nach einem der Ansprüche 1 bis 11,
**dadurch gekennzeichnet,**
daß das Entfernen des ersten und/oder zweiten Substrates und/oder des Hilfssubstrates durch Wegätzen einer Haftschicht zwischen dem jeweiligen Substrat und den Bauelementeebenen erfolgt.

13. Verfahren nach einem der Ansprüche 1 bis 12,
**dadurch gekennzeichnet,**
daß ein Trägersubstrat und/oder ein Hilfssubstrat aus Halbleitermaterial, Quarz oder Glas verwendet wird.

14. Verfahren nach einem der Ansprüche 1 bis 13,
**dadurch gekennzeichnet,**
daß ein SOI-Substrat als erstes und/oder als zweites Substrat verwendet wird.

## Claims

1. Method for producing a three-dimensional integrated circuit for the attainment of higher system gain:
Making available a first substrate (1) which contains on a first side one or several pre-fabricated component planes (3) which have a multiplicity of independent components or switching circuits side by side, components or switching circuits of several component planes forming component stacks;
Function testing of the individual components, component stacks or switching circuits of the first substrate for differentiating between operable and non-operable components, components stacks or switching circuits,
Combination of the first substrate (1) with an auxiliary substrate (8) on the first side;
Thinning or removing the first substrate (1) on the side lying opposite the first side nearly up to one or several pre-fabricated component planes;
Dividing the auxiliary substrate (8) with the connected component planes into individual chips which contain respectively operable or non-operable components, component stacks or switching circuits;
Making available a carrier substrate (9);
Adjusted depositing of chips (2), which contain operable components, component stacks or switching circuits, side by side onto the carrier substrate (9) so that a chip plane arises;
Removal of the auxiliary substrate (8);
Depositing of at least one further component plane onto the component planes of the carrier substrate.

2. Method according to claim 1,
characterised in that
depositing the further component planes comprises the following steps:
Making available a second substrate (13) which contains on a second side one or several pre-fabricated component planes (15) which have a multiplicity of independent components or switching circuits side by side, components or switching circuits of several component planes forming component stacks;
Function testing of the individual components, component stacks or switching circuits for differentiating between operable and non-operable components, component stacks or switching circuits,
Combination of the second substrate (13) with an auxiliary substrate on the second side;
Thinning or removing the second substrate (13) on the side lying opposite the second side;
Dividing the auxiliary substrate with the connected component planes into individual chips which contain respectively operable or non-operable components, component stacks or switching circuits;
Adjusted depositing of chips, which contain operable components, component stacks or switching circuits, side by side onto the component planes of the carrier substrate (9),
Removal of the auxiliary substrate;
Production of electric contacts between the components, stacks of components or switching circuits of the deposited chips and the components, stacks of components, or switching circuits on the carrier substrate, this procedural step having the capacity to already take place during deposition.

3. Method according to claim 1 or 2,
characterised in that
in order to construct a three-dimensional integrated circuit with more than two component planes the method is carried out several times in succession, the carrier substrate with the deposited component planes being used as the first substrate in each repeated performance of the method, said carrier substrate being made available by means of the respective preceding procedural steps.

4. Method according to claim 3,
characterised in that
the same carrier substrate is used several times.

5. Method according to on of the claims 1 to 4,
characterised in that
the auxiliary substrate is connected to the first and/or second substrate via an adhesive layer.

6. Method according to one of the claims 1 to 5
characterised in that
the chips are deposited on the carrier substrate or onto the component planes of the carrier substrate by means of an adhesive layer.

7. Method according to one of the claims 5 or 6,
characterised in that
an adhesive layer with passivated properties is used.

8. Method according to one of the claims 5 to 7,
characterised in that
an adhesive layer is used which effects a flattening out of the surface.

9. Method according to one of the claims 1 to 8,
characterised in that
channels, which are produced after the adjusted depositing of the individual chips between the latter, are flattened out.

10. Method according to one of the claims 2 to 9,
characterised in that
production of the electric contacts between the components, component stacks or switching circuits of the deposited chips and the components, component stacks, or switching circuits of the carrier substrate results via contact- and/or access holes (17).

11. Method according to one of the claims 1 to 10,
characterised in that
the thinning of the first and/or second substrate results from etching and/or grinding.

12. Method according to one of the claims 1 to 11
characterised in that
the removal of the first and/or second substrate and/or of the auxiliary substrate results from etching away of an adhesive layer between the respective substrate and the component planes.

13. Method according to one of the claims 1 to 12,
characterised in that
a carrier substrate and/or an auxiliary substrate made of semiconductor material, quartz or glass is used.

14. Method according to one of the claims 1 to 13,
characterised in that
an SOI substrate is used as the first and/or as the second substrate.

## Revendications

1. Procédé de fabrication d'un circuit intégré tridimensionnel avec un rendement élevé du système, procédé selon lequel on effectue les opérations suivantes :
- on réalise un premier substrat (1) comportant, sur un premier côté, un ou plusieurs plans de composants (3) dont le traitement est terminé, et qui comportent de manière juxtaposée un grand nombre de composants ou de circuits indépendants, les composants ou circuits formant des piles de composants à plusieurs plans de composants,
- on effectue des tests fonctionnels des différents composants, piles de composants et circuits du premier substrat, pour séparer les composants ou piles de composants et circuits aptes à fonctionner, de ceux qui ne le sont pas,
- on relie le premier substrat (1) à un substrat auxiliaire (8) sur un côté,
- on amincit ou on enlève le premier substrat (1) d'un côté, celui qui est opposé au premier côté, jusqu'à arriver à proximité des plans de composants plus ou moins traités,
- on divise le substrat auxiliaire (8) avec les composants reliés à celui-ci, en des puces séparées qui fonctionnent chacune, ou en composants, piles de composants ou circuits qui ne fonctionnent pas,
- on réalise un substrat de support (9),
- on applique de manière ajustée des puces (2) qui contiennent des composants fonctionnels, des piles de composants ou des circuits fonctionnels, de manière juxtaposée sur le substrat (9), pour former un nouveau plan de puces,
- on enlève le substrat auxiliaire (8),
- on applique au moins un autre plan de composants sur les plans de composants du substrat de support.

2. Procédé selon la revendication 1,
caractérisé en ce que
la mise en place d'autres plans de composants comprend les étapes de procédé suivantes :
- on fournit un second substrat (13) qui comporte, sur un second côté, un ou plusieurs plans de composants (15) dont le traitement est terminé, ayant de façon juxtaposée un grand nombre de composants indépendants ou de circuits de commutation, les composants ou circuits de plusieurs plans de composants formant une pile de composants,
- on effectue un test de fonctionnement des différents composants, piles de composants ou circuits, pour déceler les composants, piles de composants ou circuits aptes à fonctionner, de ceux qui ne fonctionnent pas,
- on relie le second substrat (13) à un substrat auxiliaire sur le second côté,
- on amincit le second substrat (13) à une face ou on l'enlève, et l'on regarde la seconde face,
- on divise le substrat auxiliaire avec les plans de composants reliés à celui-ci, pour obtenir des puces séparées qui ont des composants, piles de composants ou circuits qui fonctionnent ou ne fonctionnent pas,
- on ajuste l'application des puces qui comportent des composants, piles de composants ou circuits aptes à fonctionner, en les juxtaposant sur les plans de composants du substrat de support (9),
- on enlève le substrat auxiliaire,
- on réalise les contacts électriques entre les composants, piles de composants et circuits des puces mises en place, et des composants, piles de composants et circuits sur le substrat de support, cette étape de procédé pouvant se faire dès la mise en place des puces.

3. Procédé selon la revendication 1 ou 2,
caractérisé en ce que
pour réaliser un circuit intégré tridimensionnel avec plus de deux plans de composant, on répète plusieurs fois le procédé, successivement, et on prend comme premier substrat, à chaque répétition du procédé, le substrat de support avec les plans de composants, obtenu par l'étape de procédé chaque fois antérieure.

4. Procédé selon la revendication 3,
caractérisé en ce qu'
on utilise plusieurs fois le même substrat de support.

5. Procédé selon l'une des revendications 1 à 4,
caractérisé en ce qu'
on relie le substrat auxiliaire par une couche adhésive au premier et/ou au second substrat.

6. Procédé selon l'une quelconque des revendications 1 à 5,
caractérisé en ce qu'
on applique les puces à l'aide d'une couche adhésive sur le substrat de support ou sur les plans des composants du substrat de support.

7. Procédé selon la revendication 5 ou 6,
caractérisé en ce qu'
on utilise une couche adhésive ayant des propriétés de passivation.

8. Procédé selon l'une quelconque des revendications 5 à 7,
caractérisé en ce qu'
on utilise une couche adhésive qui assure un aplanissement de la surface supérieure.

9. Procédé selon l'une quelconque des revendications 1 à 8,
caractérisé en ce qu'
on aplanit les sillons qui sont formés entre la mise en place ajustée des différentes puces.

10. Procédé selon l'une quelconque des revendications 2 à 9,
caractérisé en ce qu'
on réalise les contacts électriques entre les composants, piles de composants et circuits des puces mises en place, et les composants, piles de composants et circuits du substrat de support, par des orifices de passage et/ou de contact (17).

11. Procédé selon l'une quelconque des revendications 1 à 10,
caractérisé en ce qu'
on amincit le premier et/ou le second substrat par attaque chimique et/ou ponçage.

12. Procédé selon l'une quelconque des revendications 1 à 11,
caractérisé en ce qu'
on enlève le premier et/ou le second substrat et/ou le substrat auxiliaire par attaque chimique d'une couche d'accrochage entre le substrat respectif et les plans des composants.

13. Procédé selon l'une quelconque des revendications 1 à 12,
caractérisé en ce qu'
on utilise un substrat de support et/ou un substrat auxiliaire en matière semi-conductrice, en quartz ou en verre.

14. Procédé selon l'une quelconque des revendications 1 à 13,
caractérisé en ce qu'
on utilise un substrat SOI comme premier et/ou second substrat.
